# EUROPEAN PATENT SPECIFICATION

(11) **EP 1 726 995 B1**
(45) Date of publication and mention of the grant of the patent: **27.08.2008**
(21) Application number: 06252734.6
(22) Date of filing: 25.05.2006
(51) Int. Cl.: G03F 7/20, G02B 1/00

(54) **Last lens of immersion lithography equipment**
Letzte Linse eines Immersionslithografiegeräts
Dernier objectif d'équipement lithographique d'immersion

(30) Priority: 25.05.2005 JP 2005152231
(43) Date of publication of application: 29.11.2006
(73) Proprietor: Tokuyama Corporation, Shuana-shi, Yamaguchi (JP)
(72) Inventor: Nawata, Teruhiko, c/o Tokuyama Corporation, Shunan-shi, Yamaguchi (JP); Inui, Yoji, c/o Tokuyama Corporation, Shunan-shi, Yamaguchi (JP); Nishijima, Eiichi, c/o Tokuyama Corporation, Shunan-shi, Yamaguchi (JP); Fukuda, Tsuguo, Sendai-shi, Miyagi (JP)
(74) Representative: Hall, Matthew Benjamin

(56) References cited:
- US-A1- 2003 094 129
- BENSALAH A ET AL: "Growth and characterization of BaLiF3 single crystal as a new optical material in the VUV region" JOURNAL OF ALLOYS AND COMPOUNDS, ELSEVIER SEQUOIA, LAUSANNE, CH, vol. 348, no. 1-2, 13 January 2003 (2003-01-13), pages 258-262, XP004396821 ISSN: 0925-8388

## Description

### BACKGROUND OF THE INVENTION

### Technical Field of the Invention

The present invention relates to a last lens for immersion lithography exposure equipment. More particularly, the present invention relates to a last lens for immersion lithography exposure equipment, composed of a crystal represented by formula BaLiF₃.

### Related Art

In a lithography process in the field of manufacturing electronic materials such as semiconductor integrated circuits, there is an increasing demand for miniaturization of a pattern transferred onto an exposure substrate. To meet this demand, an improvement in resolution of the exposure equipment has been studied.

In general, in the exposure equipment, it is known that, with a smaller exposure wavelength and a larger numerical aperture of the lens, the resolution can be improved by reducing the resolution line width. Therefore, an attempt to use, as a light source, light in a vacuum ultraviolet region with a wavelength of not more than 200 nm (for example, ArF excimer laser; oscillation wavelength 193 nm, F₂ excimer laser; oscillation wavelength 157 nm), as well as design of an optical system capable of coping with this short-wavelength light, the development of a lens material and the like have been forwarded.

In parallel with these attempts, research involving immersion lithography exposure equipment has also been made in which a liquid is filled into a portion between an exposure substrate and a last lens in an exposure equipment to substantially shorten the wavelength of light in the exposure substrate surface for improving the resolution.

The immersion lithography exposure equipment comprises at least a light source, an illumination optical system, a mask (reticule), a projection optical system, and a liquid supply/recovery apparatus, wherein exposure is carried out in such a state that a liquid is filled into a portion between a lens (last lens) provided at the front end on the exposure substrate side of the projection optical system and an exposure substrate with a resist film. Various properties including high refractive index and transmission at the wavelength of light emitted from the light source, low or no intrinsic birefringence (IBR) and stress birefringence (SBR), fastness properties to light emitted from the light source, resistance to the liquid used are required of the last lens for the immersion lithography exposure equipment.

In recent years, the results of studies on oxide materials such as MgO crystals, spinel (MgAl₂O₄) crystals, and ceramic spinel, and fluoride materials such as barium fluoride (BaF₂) crystals have been reported as materials for a last lens for an immersion lithography exposure equipment using, as a light source, light having a wavelength of 193 nm or 157 nm (John H. Burnett et al., "High-Index Materials for 193 nm and 157 nm Immersion Lithography" (US), SPIE Microlithography 30, San Jose, March 3, 2005).

### SUMMARY OF THE INVENTION

### Problems to be Solved by the Invention

MgO, however, has a high melting point of 2800°C. Therefore, crystal growth from melt is difficult. The formed crystal contains impurities, and, for light with a wavelength of 193 nm, the transmission is low although the refractive index is high. Further, since strain cannot be removed by annealing without difficulties, it is considered that SBR is large.

On the other hand, spinel crystals have a high refractive index and further have a transmission of about 75% for light with a wavelength of 193 nm. Since, however, the melting point is as high as 2000°C, it is difficult to provide a large crystal. In this formed crystal as well, strain cannot be removed without difficulties by annealing. Therefore, it is considered that SBR is large.

In the case of ceramic spinel, for a wavelength of 193 nm, the refractive index is high. Due to the influence of grain boundaries, however, up to now, only ceramic spinel having low transmission could have been produced. Further, it is considered that the formation of thick or large products is difficult.

BaF₂ crystals have a high transmission, and crystal growth from melt is easy. However, the refractive index for light with a wavelength of 193 nm is low and 1.58. Therefore, this refractive index 1.58 has no superiority over the refractive index 1.57 of synthetic quartz.

By contrast, the present inventors have found that a crystal represented by formula BaLiF₃ can meet various properties required of the last lens for the immersion lithography exposure equipment, which has led to the completion of the present invention.

Accordingly, an object of the present invention is to provide a last lens for an immersion lithography exposure equipment, composed of a crystal represented by formula BaLiF₃.

### Means for Solving Problems

The present invention has been made with a view to solving the above problems and has the following features.

The last lens for an immersion lithography exposure equipment according to the present invention is composed of a crystal represented by formula BaLiF₃. The crystal is preferably a single crystal represented by formula BaLiF₃.

The immersion lithography exposure equipment preferably comprises a light source which emits light with a wavelength of not more than 200 nm. More specifically, the immersion lithography exposure equipment preferably comprises an ArF excimer laser oscillator or an F₂ excimer laser oscillator.

### Effect of the Invention

In the last lens for the immersion lithography exposure equipment according to the present invention, for the wavelength of light used in a light source, preferably for a wavelength of not more than 200 nm, a high refractive index, a high transmission, and low SBR can be realized, and the resolution of the exposure equipment can easily be improved.

Further, for the last lens for an immersion lithography exposure equipment according to the present invention, resistance to a liquid used in immersion and resistance to light used in a light source each are also on a level that poses substantially no problem.

### BRIEF DESCRIPTION OF THE DRAWINGS

Fig. 1 is a schematic diagram showing the principle of immersion lithography exposure equipment.
Fig. 2 is a diagram showing the results of measurement of vacuum ultraviolet light transmission of a single crystal of BaLiF₃ prepared in the working example 1.
Fig. 3 is a diagram showing the dependence of refractive index on wavelength for a single crystal of BaLiF₃ prepared in the working example 1.

### DETAILED DESCRIPTION OF THE INVENTION

The present invention will be described in more detail.

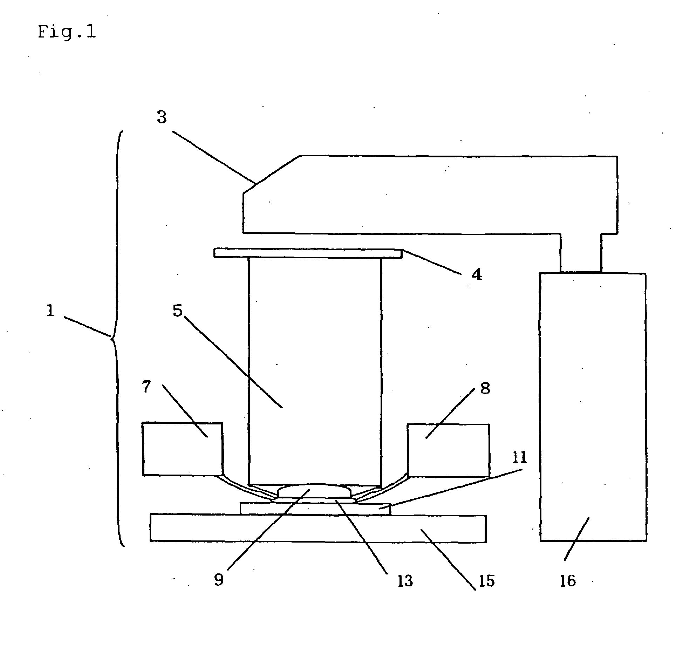

Fig. 1 is a schematic diagram showing an example of the principle of immersion lithography exposure equipment.

In Fig. 1, the immersion lithography exposure equipment 1 includes an illumination optical system 3 and a projection optical system 5, and a mask (reticule) 4 is interposed between the illumination optical system 3 and the projection optical system 5. The immersion lithography exposure equipment 1 further includes liquid supply/recovery apparatuses 7, 8, a stage 15 which can move an exposure substrate, and a laser beam source 16. Exposure is carried out in such a state that a liquid 13 has been filled into a portion between a last lens 9 provided at the front end on the exposure substrate side of the projection optical system 5 and the exposure substrate 11 having a resist film. The pattern of the mask (reticule) 4 can be reduced for transfer onto the exposure substrate 11. In the embodiment shown in the drawing, the liquid 13 is held only between the last lens 9 and the exposure substrate 11. The present invention, however, is not limited to this embodiment, and the whole exposure substrate 11 may be immersed in the liquid 13. Various studies on liquids such as fluoro-solvents as the liquid 13 have been carried out. At the present time, however, pure water is widely used as the liquid 13 because of its freedom from contamination of an object to be exposed, such as semiconductor, low viscosity, and high refractive index (refractive index (20°C) of pure water for light with a wavelength of 193 nm: 1.44).

The immersion lithography exposure equipment according to the present invention preferably comprises, as a light source, a laser beam source which emits a laser beam with a wavelength of not more than 200 nm. More specifically, the immersion lithography exposure equipment preferably comprises an ArF excimer laser oscillator (oscillation wavelength 193 nm) or an F₂ excimer laser oscillator (oscillation wavelength 157 nm). The use of the above short-wavelength light as the light source is expected to improve the resolution of the exposure equipment.

As described above, various properties including high refractive index and transmission at the wavelength of light emitted from the light source, low or no IBR and SBR, fastness properties to light emitted from the light source, resistance to the liquid used are required of the last lens for the immersion lithography exposure equipment.

The refractive index is preferably higher because the numerical aperture can be increased without increasing the aperture of the last lens. The refractive index of the last lens, however, is preferably at least higher than that of the liquid filled into a portion between the last lens and the exposure substrate, because the angle of the beam of light projected from the last lens onto the exposure substrate can easily be increased and, consequently, the numerical aperture can easily be increased.

Further, preferably, regarding birefringence, the last lens material has no anisotropy. For example, cubic single crystals and amorphous materials are preferred. Further, from the viewpoint of SBR, materials having a low melting point are preferred in order to render stain removable by annealing.

Regarding the transmission, at the wavelength of light emitted from the light source, higher transmission is more desirable.

BaLiF₃ as a material for constituting the last lens according to the present invention is a cubic crystal having a melting point of about 850°C and is disclosed in Japanese Patent Laid-Open No. 228802/2002 as a vitreous material which can be an alternative to quartz glass, particularly as an optical member for a vacuum ultraviolet region having no significant deliquescence and cleavage and having a high level of fastness properties to high energy light. Even in a wavelength region of not more than 200 nm, the transmission of this material can be compared favorably with that of CaF₂. In particular, regarding the internal transmission for light with a wavelength of 193 nm, the value is described to be substantially equal to the internal transmission of CaF₂. The internal transmission of CaF₂ for light with a wavelength of 193 nm is known to be substantially 100%. Accordingly, based on the disclosure of this publication, it is expected that the internal transmission of BaLiF₃ also is similar to and probably not less than 99.9% for light with a wavelength of 193 nm.

Further, WO 03/044570 and U.S. Patent No. 2003/0094128 disclose that BaLiF₃ is used as an optical member for regulating the chromatic aberration.

In these literatures, however, there is no description on a last lens for an immersion lithography exposure equipment, composed of BaLiF₃. The reason for this is believed to reside in that, since there is an empirical rule that, in metal fluoride crystals, the refractive index increases with increasing the atomic weight of the metal as the constituent element, the use of BaLiF₃ containing a light element such as Li (lithium) as a high-refractive index material has been overlooked.

As a result of extensive and intensive studies conducted by the present inventors, however, it was found that, in fact, BaLiF₃ has a high refractive index of about 1.64 for light with a wavelength of 193 nm and is an excellent material that, because it belongs to a cubic material, a single crystal thereof can meet the above-described various properties including the refractive index and IBR required of the last lens.

BaLiF₃ used in the present invention can be produced by a conventional crystal growth method, and the production method thereof is not particularly limited. Specifically, for example, the use of a Czochralski method (CZ method) is preferred, because SBR derived from the presence of the residual stress strain of the resultant crystal can be reduced and, further, a large single crystal can easily be produced.

The method for growing a single crystal of BaLiF₃ by the CZ method will be described.

Specifically, for example, as disclosed in Japanese Patent Laid-Open No. 228802/2002, powdered lithium fluoride (LiF) and barium fluoride (BaF₂) are used as raw materials. In this case, in consideration of the occurrence of slight incongruent melting, the raw materials are mixed together at a molar mixing ratio of LiF : BaF₂ = x : (1 - x) wherein 0.55 < x < 0.65. The mixture is placed in a platinum crucible. Thereafter, the crucible is heated in a CZ crystal growth furnace to a temperature of 850°C or above to melt the mixture. A seed crystal of BaLiF₃ is brought into contact with the raw material melt within the crucible, and the seed crystal is gradually pulled up while rotating the seed crystal. Thus, a single crystal of BaLiF₃ can be grown and produced.

In this case, the use of a carbon crucible is also preferred. When the above x is 0.55 or less, BaF₂ is more likely to precipitate than BaLiF₃. On the other hand, when the above x is 0.65 or more, LiF is likely to precipitate in the resultant single crystal of the resultant BaLiF₃, and this case is disadvantageous from the viewpoint of yield, because the resultant crystal is in many cases opaque. Studies conducted by the present inventors, however, have revealed that, even when x is 0.55 or less, the BaF₂ crystal is not always precipitated instead of the single crystal of BaLiF₃ and that, when the BaF₂ crystal is not precipitated even under such condition, a single crystal having higher transmission can be obtained. Accordingly, when importance is attached to transmission, the x value is preferably regulated to 0.52 < x ≤ 0.55, particularly preferably 0.53 ≤ x ≤ 0.55.

From the viewpoint of providing a single crystal having no significant coloration and internal strain or the like, preferably, lithium fluoride and barium fluoride used as the raw materials have the highest possible purity. For example, the use of raw materials of which the total content of cationic impurities other than alkaline earth metals is less than 1 ppm is preferred.

Lithium fluoride and barium fluoride as the raw materials have a high level of water absorption. Therefore, properties such as transmission can be improved by dehydration in a growth furnace before melting. The dehydration is preferably carried out at a temperature of 200 to 650°C under a reduced pressure of 10⁻⁵ to 10⁻² Pa for 3 hr or longer in consideration of sublimation of the raw materials and dehydration efficiency. Further, a method may be adopted in which powdered lithium fluoride and barium fluoride as raw materials for growth are mixed together at a molar mixing ratio of LiF : BaF₂ = x : (1-x), wherein 0.55 < x < 0.65, alternatively when importance is attached to transmission of resultant single crystal, preferably 0.52 < x ≤ 0.55, more preferably 0.53 ≤ x ≤ 0.55, and the mixture is previously sintered or vitrified for a volume reduction.

Inert gases such as Ar, He, Ne, and N₂ can be used as an atmosphere for melting of the raw materials and the growth of a crystal. The use of a fluorine-containing gas such as CF₄ or HF, however, can improve properties such as transmission. The fluorine-containing gas may be used as a mixture with the inert gas at any mixing ratio. Further, the fluorine-containing gases may be used either solely or as a mixture of a plurality of different fluorine-containing gases. The pressure of the atmosphere for crystal growth can be properly selected so that the sublimation or evaporation of the raw materials does not affect the stability of the crystal growth.

The orientation of the growth of single crystal can be properly selected based on the orientation of the seed crystal. In the last lens according to the present invention, the growth orientation is preferably <100> or <111>.

A last lens can be produced by optionally annealing the single crystal thus obtained at 600 to 800°C and then fabricating the crystal into a lens form by a conventional method. From the viewpoint of satisfying the function as the last lens, the root mean square of SBR is preferably reduced to not more than 1.0 nm/cm.

As described above, unlike MgO and spinel, BaLiF₃ has a low melting point of about 850°C. Therefore, a single crystal having a large diameter can easily be grown and, in addition, strain is less likely to occur at the time of crystal growth. Further, even though SBR occurs during the growth of a single crystal, removal of strain by annealing enables SBR to be surely reduced by post treatment. This property of BaLiF₃ is very advantageous in the mass production of the last lens.

The single crystal of BaLiF₃ is also advantageous in that, unlike ceramic spinel as sinter, this single crystal does not undergo the influence of grain boundaries.

The shape and size of the last lens may be properly designed in accordance with the construction of the projection optical system in the immersion lithography exposure equipment in which this lens is incorporated and, in addition, by taking into consideration the construction of the illumination optical system, and are not particularly limited. For example, a last lens having a diameter of 80 to 300 mm (more commonly a diameter of 100 to 300 mm) and a center thickness of 30 to 200 mm (more commonly a center thickness of 50 to 200 mm can be obtained from a straight barrel part of the resultant single crystal of BaLiF₃ by the CZ method.

The last lens thus obtained may be used in combination with other members, for example, various lenses and mirrors to constitute a projection optical system. The projection optical system may be used in combination with, for example, a mask (reticule) as an original plate of a pattern, a laser beam source such as an ArF excimer laser oscillator or an F₂ excimer laser oscillator, an illumination optical system constructed so as to illuminate the mask (reticule) with light from the light source, a stage which can move an exposure substrate as an object to be exposed, and a liquid supply/recovery apparatus to provide an immersion lithography exposure equipment.

The following Examples further illustrate the present invention. However, it should be noted that the present invention is not limited to these Examples only.

### Example 1

Powdered lithium fluoride (LiF) and barium fluoride (BaF₂) were mixed together at a molar ratio of LiF _{:} BaF₂ = 0.60 : 0.40, the mixture was placed in a platinum crucible (inner diameter 250 mm, height 100 mm), and the crucible was placed in a CZ crystal growth furnace. The inside of the furnace was then kept at a degree of vacuum of not more than 1 x 10⁻³ Pa, and the crucible was heated to raise the temperature to 600°C over a period of 24 hr. CF₄ gas having a purity of 99.999% was then introduced into the furnace to bring the pressure within the furnace to the atmospheric pressure. Thereafter, the crucible was heated to raise the temperature to 900°C over a period of 2 hr, thereby melting the mixture.

Next, a seed crystal of BaLiF₃ in its <100> orientation plane as a contact surface was brought into contact with the raw material melt within the crucible. This seed crystal was pulled up at a rate of 2.0 mm/min while rotating the seed crystal at 12 rpm to grow a single crystal of BaLiF₃. The single crystal thus obtained had a size of 180 mm in total length, 130 mm in length of straight barrel part, and 155 mm in diameter of straight barrel part.

A disk-shaped sample having a diameter of 150 mm and a thickness of 120 mm was prepared from the straight barrel part in the single crystal and was then annealed at the maximum temperature of 750°C in a CF₄ atmosphere, followed by measurement of SBR with an automatic birefringence distribution measuring device (EXICOR 450AT, manufactured by Hinds Instruments, Inc.; light source 633 nm).

As a result, SBR of the single crystal sample of BaLiF₃ was 0.8 nm/cm in terms of the average least square within the measured plane.

A disk-shaped sample having a diameter of 20 mm and a thickness of 1.0 mm was prepared as a measuring sample from the annealed single crystal of BaLiF₃. The vacuum ultraviolet light transmission of the sample was measured in a nitrogen atmosphere having an oxygen content of not more than 0.2 ppm with a VUV transmission measuring device (KV-201, manufactured by Japan Spectroscopic Co., Ltd.).

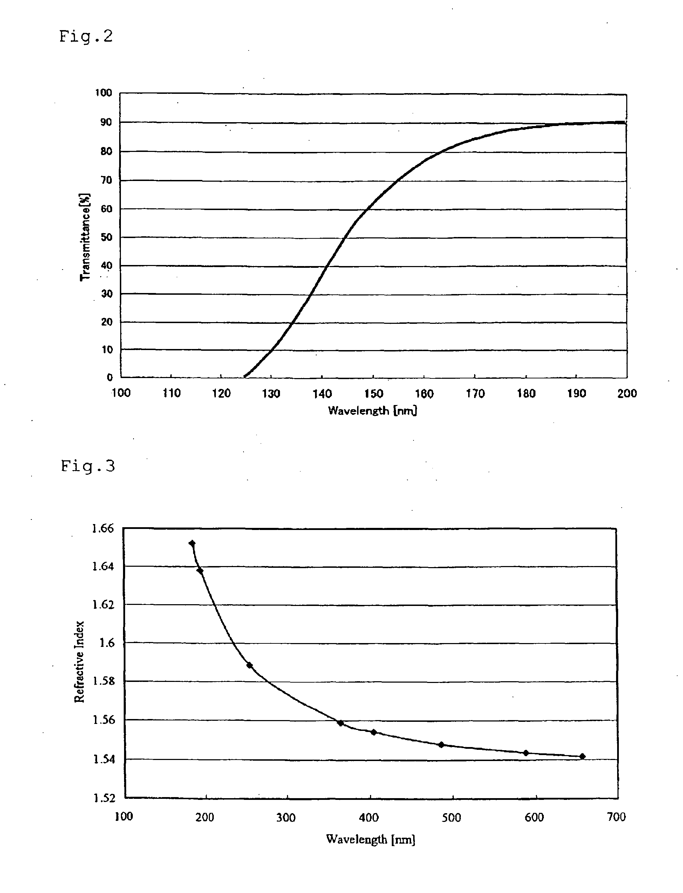

The results are shown in Fig. 2. The results of the measurement of transmission include the influence of surface reflection and the like but was still as high as about 90% at 193 nm, suggesting that the internal transmission from which the influence of the surface reflection and the like has been eliminated is very high.

Further, a triangular prism of which the section was in a regular triangular form (one side 25 mm) and which had a length of 30 mm was prepared as a sample from the annealed single crystal of BaLiF₃. The absolute refractive index in the wavelength range of 656 nm to 185 nm was measured by the minimum deviation method (1013 hPa, 25°C) (measurement equipment: goniometer spectrometer model 1, manufactured by Moller-Wedel).

The results are shown in Fig. 3. The absolute refractive index at the wavelength 193 nm calculated from the results of the measurement was 1.64, that is, was much higher than the absolute refractive index of barium fluoride 1.58 (literature value), indicating that the sample is very advantageous as a last lens for an immersion lithography exposure equipment. Further, IBR of a single crystal of BaLiF₃ before annealing was measured at a wavelength of 193 nm by the method described in an article of John H. Burnett et al. (John H. Burnett et al., "Intrinsic birefringence in calcium fluoride and barium fluoride", Physical Review B, Volume 64, 241102 (R)-1-4, Nov. 29, 2001) and was found to be 25.4 nm/cm.

### Example 2

A single crystal of BaLiF₃ was obtained in the same manner as in Example 1, except that LiF and BaF₂ were mixed together (LiF : BaF₂ molar ratio = 0.53 : 0.47) and a graphite crucible was used. The single crystal thus obtained had a size of 110 mm in total length, 60 mm in length of straight barrel part, and 100 mm in diameter of straight barrel part.

In the same manner as in Example 1, the single crystal of BaLiF₃ was annealed, and a disk-shaped sample having a diameter of 20 mm and a thickness of 10 mm was prepared as a measuring sample from the annealed single crystal of BaLiF₃. The vacuum ultraviolet light transmission of the sample was measured in a nitrogen atmosphere having an oxygen content of not more than 0.2 ppm with a VUV transmission measuring device (KV-201, manufactured by Japan Spectroscopic Co., Ltd.).

As a result, the transmission at 193 nm (a value including the influence of surface reflection and the like) was about 70%. Therefore, the internal transmission from which the influence of the surface reflection and the like has been eliminated was calculated to be about 80%.

## Claims

1. A last lens for immersion lithography exposure equipment, composed of a crystal represented by formula BaLiF₃.

2. The last lens for the immersion lithography exposure equipment according to claim 1, wherein said immersion lithography exposure equipment comprises a light source which emits light with a wavelength of not more than 200 nm.

3. The last lens for the immersion lithography exposure equipment according to claim 1 or 2, wherein said immersion lithography exposure equipment comprises an ArF excimer laser oscillator or an F₂ excimer laser oscillator.

4. The last lens for the immersion lithography exposure equipment according to claim 1,2, or 3, wherein said crystal is a single crystal represented by formula BaLiF₃.

## Patentansprüche

1. Letzte Linse für ein Immersionslithographie-Belichtungsgerät, die aus einem Kristall besteht, das durch die Formel BaLiF₃ dargestellt ist.

2. Letzte Linse für das Immersionslithographie-Belichtungsgerät gemäß Anspruch 1, wobei das Immersionslithographie-Belichtungsgerät eine Lichtquelle umfasst, die Licht mit einer Wellenlänge von nicht mehr als 200 nm emittiert.

3. Letzte Linse für das Immersionslithographie-Belichtungsgerät gemäß Anspruch 1 oder 2, wobei das Immersionslithographie-Belichtungsgerät einen ArF-Excimer-Laseroszillator oder einen F₂-Excimer-Laseroszillator umfasst.

4. Letzte Linse für das Immersionslithographie-Belichtungsgerät gemäß Anspruch 1, 2 oder 3, wobei das Kristall ein Einkristall ist, das durch die Formel BaLiF3 dargestellt ist.

## Revendications

1. Dernière lentille d'un équipement d'exposition pour lithographie en immersion, composée d'un cristal représenté par la formule BaLiF₃.

2. Dernière lentille d'un équipement d'exposition pour lithographie en immersion selon la revendication 1, dans laquelle ledit équipement d'exposition pour lithographie en immersion comprend une source de lumière qui émet de la lumière à une longueur d'onde non supérieure à 200 nm.

3. Dernière lentille d'un équipement d'exposition pour lithographie en immersion selon la revendication 1 ou 2, dans laquelle ledit équipement d'exposition pour lithographie en immersion comprend un oscillateur de laser à excimère ArF ou un oscillateur de laser à excimère F₂.

4. Dernière lentille d'un équipement d'exposition pour lithographie en immersion selon la revendication 1, 2 ou 3, dans laquelle ledit cristal est un monocristal représenté par la formule BaLiF₃.
